(19) **Europäisches Patentamt**

**European Patent Office**

**Office européen des brevets**

(11) **EP 0 685 940 B1**

(12) **EUROPÄISCHE PATENTSCHRIFT**

(45) Veröffentlichungstag und Bekanntmachung des Hinweises auf die Patenterteilung:
**01.08.2001   Patentblatt 2001/31**

(51) Int Cl.$^{7}$: **H03K 17/12**

(21) Anmeldenummer: **95107901.1**

(22) Anmeldetag: **24.05.1995**

(54) **Pulsweitenmodulierter Schaltwandler zum Betrieb elektrischer Verbraucher**

Pulse with modulated switching converter for operation of electric loads

Convertisseur modulé par la largeur d'impulsion pour le fonctionnement de consommateurs d'électricité

(84) Benannte Vertragsstaaten:
**DE FR IT**

(30) Priorität: **31.05.1994  DE 4419006**

(43) Veröffentlichungstag der Anmeldung:
**06.12.1995   Patentblatt 1995/49**

(73) Patentinhaber: **Hella KG Hueck & Co.**
**59552 Lippstadt (DE)**

(72) Erfinder:
• **Daub, Wolfgang**
  **D-59558 Lippstadt (DE)**
• **Lange, Ulrich-Volker**
  **D-59597 Erwitte (DE)**

(56) Entgegenhaltungen:
EP-A- 0 547 276          EP-A- 0 581 016
DE-A- 3 816 536          US-A- 4 814 965
US-A- 4 977 333          US-A- 5 115 156

**Beschreibung**

Pulsweitenmodulierter Schaltwandler zum Betrieb elektrischer Verbraucher, insbesondere in Fahrzeugen, der zum einen mit der Versorgungsspannung und zum anderen mit dem Verbraucher verbunden ist, und aus einem Schaltwandler, einer Schaltung zur Erzeugung von Signalen zur Ansteuerung des Schaltwandlers und einem Eingangs-Pufferkondensator sowie einem Ausgangs-Glättekondensator besteht, wobei dem Schaltwandler mindestens ein zweiter Schaltwandler parallel geschaltet ist, die Schaltwandler über einen gemeinsamen Eingangs-Summenpunkt verbunden sind, die Schaltwandler über einen gemeinsamen Ausgangs-Summenpunkt verbunden sind, den Schaltwandlern) ein gemeinsamer Eingangs-Pufferkondensator zugeordnet ist, der mit dem Eingangs-Summenpunkt verbunden ist, den ein gemeinsamer Ausgangs-Glättungskondensator zugeordnet ist, der mit dem Ausgangs-Summenpunkt verbunden ist, und die Schaltwandler von der Schaltung zur Reduzierung der effektiven Strombelastung des gemeinsamen Eingangs-Pufferkondensators sowie des gemeinsamen Ausgangs-Glättungskondensators phasenverschoben angesteuert werden.

Aus der deutschen Offenlegungsschrift DE 39 08 338 A1 ist eine Einrichtung zum Ansteuern einer Last, insbesondere in Kraftfahrzeugen bekannt, die einen pulsweitenmodulierten Schaltwandler und insbesondere einen sogenannten Drossel-Abwärtswandler aufweist. Dieser ist zum einen mit der batteriegestützten Versorgungsspannung des Fahrzeuges und zum anderen mit dem Verbraucher verbunden. Der pulsweitenmodulierte Schaltwandler besteht aus dem Schaltwandler, einer Schaltung zur Erzeugung von Signalen zur Ansteuerung des Schaltwandlers und Puffer- bzw. Glättungskondensatoren.

Bei dem bekannten Schaltwandler erweist sich als nachteilig, dass zur Ansteuerung von Lasten, die hohe Leistung aufnehmen, insbesondere der Eingangs-Pufferkondensator hoch belastet wird. Es liegt somit eine hohe Wechselstrombelastung für den Kondensator vor, der zudem eine hohe Schaltfestigkeit aufweisen muß. Dies bedingt, dass der Kondensator ein kostenintensives Bauteil ist. Zudem erweist sich bei der bekannten Ausführung des Schaltwandlers als nachteilig, dass die verwendeten Schaltelemente des Schaltwandlers, wenn hohe Ströme geschaltet werden müssen, kostenintensive Bauteile sind.

Aus der US-A-4 814 965 ist ein pulsweitenmodulierter Schaltwandler zum Betrieb elektrischer Verbraucher bekannt, der zum einen mit der Versorgungsspannung und zum anderen mit dem Verbraucher verbunden ist und aus einem Schaltwandler einer Ansteuerschaltung zur Erzeugung von Signalen zur Ansteuerung des Schaltwandlers und einem Eingangs-Pufferkondensator sowie einem Ausgangs-Glättungskondensator besteht, wobei dem Schaltwandler mindestens ein zweiter Schaltwandler parallel geschaltet ist, so dass die Schaltwandler über einen gemeinsamen Eingangs-Summenpunkt verbunden sind, die Schaltwandler über einen gemeinsamen Ausgangs-Summenpunkt verbunden sind, den Schaltwandlern ein gemeinsamer Eingangs-Pufferkondensator zugeordnet ist, der mit dem Eingangs-Summenpunkt verbunden ist, den Schaltwandlern ein gemeinsamer Ausgangs-Glättungskondensator zugeordnet ist, der mit dem Ausgangs-Summenpunkt verbunden ist und die Schaltwandler von der Ansteuerschaltung zur Reduzierung der effektiven Strombelastung des gemeinsamen Eingangs-Pufferkondensators sowie des gemeinsamen Ausgangs-Glättungskondensators phasenverschoben angesteuert werden. Bei der vorbekannten Schaltung erweist sich als nachteilig, dass die Ansteuerung aufwendig gestaltet ist.

Der Erfindung liegt die Aufgabe zugrunde, einen Schaltwandler für den Betrieb von elektrischen Verbrauchern in Fahrzeugen zu schaffen, der einfach und kostengünstig herstellbar ist, einen hohen Wirkungsgrad aufweist und die Belastung der Kondensatoren minimiert.

Die Aufgabe wird erfindungsgemäß durch die Merkmale des Anspruchs 1 gelöst.

Durch die kennzeichnenden Merkmale des Anspruchs 1 ergibt sich eine besonders einfache und günstige Ausführungsform eines pulsweitenregulierten Schaltwandlers mit einem besonders großen Leistungshub, zum Beispiel für die Ansteuerung eines Lüfters in Kraftfahrzeugen und einer minimalen Belastung für die gemeinsamen Kondensatoren.

Als besonders vorteilhaft hat es sich dabei erwiesen, dass das Rechtecksignal zur Erzeugung einer konstanten Phasenverschiebung von 180 Grad symmetrisch ausgebildet ist.

Ein Ausführungsbeispiel ist in den Zeichnungen dargestellt und wird im folgenden anhand dieser beschrieben.

Es zeigen

Figur 1     eine Prinzipdarstellung eines pulsweitenmodulierten Schaltwandlers;

Figur 2     eine erfindungsgemäße Ausführung einer Schaltung zur Ansteuerung zweier Schaltwandler.

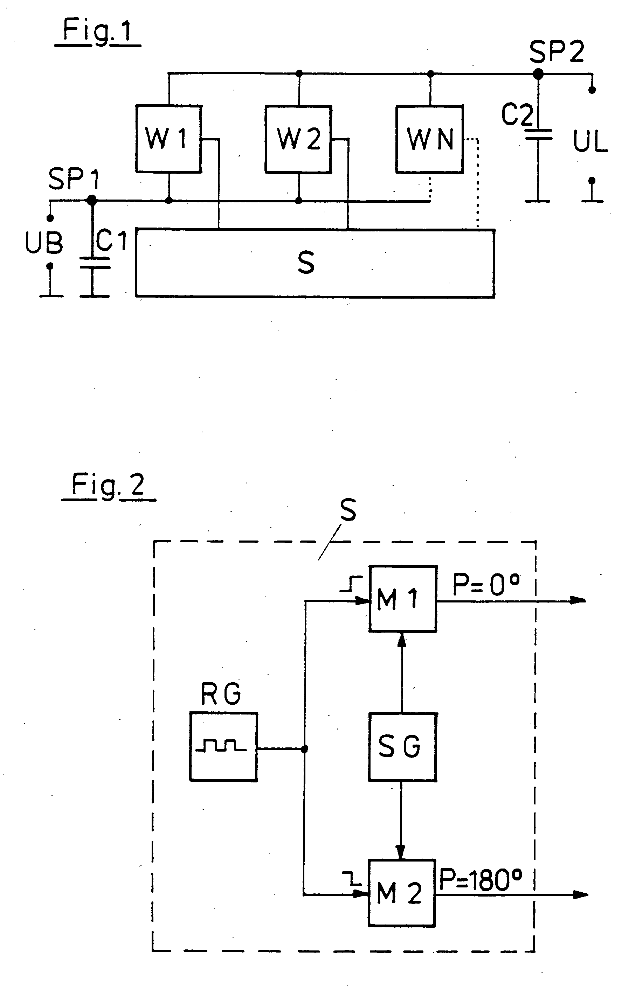

Figur 1 zeigt eine Prinzipdarstellung eines pulsweitenmodulierten Schaltwandlers. Der pulsweitenmodulierte Schaltwandler weist dabei N Schaltwandler (W1, W2, ..., WN) auf, die in Parallelschaltung zueinander angeordnet sind. Jeder der Schaltwandler (W1, W2, ..., WN) ist elektrisch leitend mit einer Schaltung (S) verbunden, die Signale zur Ansteuerung der einzelnen Schaltwandler (W1, W2, ..., WN) erzeugt. Die Spannungsversorgung der Schaltung (S) ist in dieser Prinzipdarstellung nicht gezeigt.

Die Eingänge der Schaltwandler (W1, W2, ..., WN) sind auf einen Eingangs-Summenpunkt (SP1) zusammengeführt. Dieser Eingangs-Summenpunkt (SP1) ist über einen Eingangs-Pufferkondensator (C1), der als gemeinsamer Pufferkondensator (C1) für alle Schaltwandler (W1, W2, ..., WN) dient, mit Masse verbunden. Parallel zu dem Pufferkondensator (C1) befindet sich der Versorgungsspannungs-Anschluß (UB) des batteriegestützten Versorgungsnetzes des Fahrzeuges. Die Ausgänge der Schaltwandler (W1, W2, ..., WN) sind auf einen Ausgangs-Summenpunkt (SP2) zusammengeführt. Dieser Ausgangs-Summenpunkt (SP2) ist über einen Ausgangs-Glättungskondensator (C2), der als gemeinsamer Glättungskondensator (C2) für alle Schaltwandler (W1, W2, ..., WN) dient, mit Masse verbunden. Parallel zu dem Glättungskondensator (C2) befindet sich der Anschluß für den elektrischen Verbraucher, an dem eine Lastspannung (UL) anliegt.

Die Schaltwandler, (W1, W2, ..., WN) können dabei von unterschiedlicher Bauart sein und zum Beispiel als Aufwärtswandler, Abwärtswandler, invertierende Wandler, Eintakt-Sperrwandler, Eintakt-Durchflußwandler und sogar als Gegentakt-Wandler ausgeführt sein.

Je nach Bauart der Schaltwandler (W1, W2, ..., WN) tritt im Eingang und/oder im Ausgang ein geschalteter Wechselstrom auf, welcher mit Hilfe von Kondensatoren (C1, C2) gepuffert bzw. geglättet werden muß.

Im folgenden wird das Funktionsprinzip des in Figur 1 dargestellten pulsweitenmodulierten Schaltwandlers beschrieben. Um die Wechselstrombelastung der Kondensatoren (C1, C2) zu minimieren, werden die Schaltwandler (W1, W2, ..., WN) phasenverschoben von der Schaltung (S) angesteuert. In einem ersten Ausführungsbeispiel wird bei N parallel geschalteten Schaltwandlern (W1, W2, ..., WN) das hier nicht gezeigte Schaltelement des zweiten Schaltwandlers (W2) mit der Abschaltflanke des Schaltelementes des ersten Schaltwandlers (W1) angesteuert, das Schaltelement des dritten Schaltwandlers (W3) mit der Abschaltflanke des Schaltelementes des zweiten Schaltwandlers (W2) und das Schaltelement des i-ten Schaltwandlers (Wi) mit der Abschaltflanke des Schaltelementes des (i-1)-ten Schaltwandlers (W(i-1)) angesteuert.

Die Phasenverschiebung (P) bei einem System mit N parallel geschalteten Schaltwandlern (W1, W2, ..., WN), mit der ein Wandler angesteuert wird, errechnet sich aus:

$$P(i) = (i-1) * (T_{EIN}/T * 2 * \pi) \text{ für } 0 <= T_{EIN} < T$$

mit

$T_{EIN} =$ Einschaltzeit der Schaltelemente
$T$ = Periodendauer
$i$ = Laufindex.

$T_{EIN}$ entspricht somit der Einschaltzeit des anzusteuernden Schaltwandlers in Abhängigkeit von der Ansteuerung durch die Schaltung (S).

Bei einer deretigen Erzeugung der Phasenverschibung (P) wird auf einfache Weise eine Synchronisierung bei der Ansteuerung der Schaltwandler (W2, ..., WN) erreich. Durch das verzögerte Ansteuern der Schaltwandler (W2, ..., WN) kann zudem eine Störverminderung erreicht werden.

Bei dem obigen Beispiel, bei dem N Schaltwandler (W1, W2, ..., WN) parallel geschaltet sind, wird der zweite Schaltwandler (W2) um die Phase

$$P(2) = 1 * (2 * \pi)/N$$

verschoben angesteuert, der dritte Schaltwandler (W3) um die Phase

$$P(3) = 2 * (2 * \pi)/N$$

verschoben angesteuert und der i-te Schaltwandler (Wi) um die Phase

$$P(i) = (i-1) * (2 * \pi)/N$$

verschoben angesteuert. Dies ist auch die Formel aus der sich die Phasenverschiebung (P) bei Verwendung von N parallel geschalteten Schaltwandlern (W1, W2, ..., WN) ergibt, mit der ein Wandler angesteuert wird.

Hierbei erweist sich als vorteilhaft, daß der Schaltungsaufwand zur Ansteuerung der Schaltwandler (W1, W2, ..., WN) gering ist, da es zum Beispiel keine Synchronisationsprobleme bei der Ansteuerung der Schaltwandler (W1, W2, ..., WN) durch die Schaltung (S) gibt. Zudem gibt es keine Einschränkungen bezüglich des Verhältnisses der Einschaltzeit zur Periodendauer.

Je nach dem zu betreibenden elektrischen Verbraucher und dessen Leistungsaufnahme bestimmt sich die Anzahl der zu verwendenden Schaltwandler (W1, W2, ..., WN) in Parallelschaltung. Ist der Verbraucher zum Beispiel ein in der Drehzahl zu variierender Elektromotor, so kann die Verbindung der Schaltung (S) mit einem Sollwertgeber (SG) eine Steuerung der Drehzahl des Elektromotors ermöglichen.

In Figur 2 ist eine erfindungsgemäße Ausführung einer in Figur 1 gezeigten Schaltung (S) zur Ansteuerung von zwei parallel geschalteten Schaltwandlern (W1, W2), die in Figur 2 nicht eingezeichnet sind, dargestellt. Die Schaltung weist einen Rechteckgenerator (RG) auf, der ein bekanntes Timerbauteil sein kann und an seinem Ausgang ein symmetrisches Rechtecksignal erzeugt. Der Rechteckgenerator (RG) ist dabei mit je einem Triggereingang eines ersten Monoflops (M1) und eines zweiten Monoflops (M2) verbunden. Das erste Monoflop (M1) wird dabei durch die ansteigende Flanke des Rechtecksignals und das zweite Monoflop (M2) durch die abfallende Flanke des Rechtecksignals getriggert. Somit entsteht bezüglich der Ausgangssignale der Monoflops (M1, M2) eine Phasenverschiebung (P) von 180 Grad. Zur Vorgabe der von dem elektrischen Verbraucher aufgenommenen Leistung ist die Schaltung mit einem Sollwertgeber (SG) verbunden, der in bekannter Weise als ein Potentiometer oder ein Stufenschalter ausgebildet sein kann. Dieser Sollwertgeber (SG) ist mit Kippzeit-Steuereingängen sowohl des ersten Monoflops (M1) als auch des zweiten Monoflop (M2) verbunden. Der Sollwertgeber (SG) bestimmt die Kippzeit der Monoflops (M1, M2). Die Kippzeit der Monoflops (M1, M2) entspricht der Pulsweite. Weisen die Monoflops (M1, M2) einen identischen Aufbau auf, so wird aufgrund der vollkommen symmetrischen Beschaltung eine hohe Genauigkeit zwischen den pulsweitenmodulierten, an den Ausgängen der Monoflops (M1, M2) anliegenden Signalen erreicht. Zudem wird eine große Störsicherheit erreicht. Das erste Monoflop (M1) ist mit dem hier nicht gezeigten ersten Schaltwandler (W1) verbunden. Der Ausgang des zweiten Monoflops (M2) ist mit dem hier nicht gezeigten zweiten Schaltwandler (W2) verbunden. Die Schaltwandler (W1, W2) sind dabei, wie oben angeführt, in Parallelschaltung angeordnet. Sind die Schaltwandler (W1, W2) beispielhaft als Abwärtswandler ausgebildet, wird die Belastung insbesondere des gemeinsamen Eingangs-Pufferkondensators (C1) verringert, zudem kann die Baugröße der Speicherdrosseln der Schaltwandler (W1, W2) kleiner gewählt werden, wodurch sich ein kostengünstiger Aufbau, ein guter Wirkungsgrad und eine kompakte Bauform des pulsweitenmodulierten Schaltwandlers ergibt.

Durch die phasenverschobene Ansteuerung parallel geschalteter Schaltwandler (W1, W2, ..., WN), die jeweils gemeinsame Puffer- und Glättungskondensatoren (C1, C2) aufweisen, ergeben sich im Fahrzeugbereich unterschiedlichste Anwendungen, wie zum Beispiel die Lüftersteuerung, die Spannungswandlung des Bordnetzes oder auch die Dimmung des Fahrlichtes. Weitere Anwendungen sind nicht ausgeschlossen.

Bezugszeichenliste

Pulsweitenmodulierter Schaltwandler zum Betrieb elektrischer Verbraucher

| C1 | Eingangs-Pufferkondensator |
| C2 | Ausgangs-Glättungskondensator |
| M1, M2 | Monoflops |
| P | Phasenverschiebung |
| s | Steuer-Schaltung |
| SG | Sollwertgeber |
| SP1 | Eingangs-Summenpunkt |
| SP2 | Ausgangs-Summenpunkt |
| RG | Rechteckgenerator |
| UB | batteriegestützte Versorgungsspannung |
| UL | Ausgangsspannung |
| W1, W2, ..., WN | Schaltwandler |

**Patentansprüche**

1. Pulsweitenmodulierter Schaltwandler zum Betrieb elektrischer Verbraucher, insbesondere in Fahrzeugen, der zum einen mit der Versorgungsspannung (UB) und zum anderen mit dem Verbraucher verbunden ist, und aus einem Schaltwandler (W1), einer Schaltung (S) zur Erzeugung von Signalen zur Ansteuerung des Schaltwandlers (W1) und einem Eingangs-Pufferkondensator (C1) sowie einem Ausgangs-Glättungskondensator (C2) besteht, wobei dem Schaltwandler (W1) mindestens ein zweiter Schaltwandler (W2) parallel geschaltet ist, die Schaltwandler (W1, W2,...., WN) über einen gemeinsamen Eingangs-Summenpunkt (SP1) verbunden sind, die Schaltwandler (W1, W2, ..., WN) über einen gemeinsamen Ausgangs-Summenpunkt (SP2) verbunden sind, den Schaltwandlern (W1, W2,...., WN) ein gemeinsamer Eingangs-Pufferkondensator (C1) zugeordnet ist, der mit dem Eingangs-Summenpunkt (SP1 ) verbunden ist, den Schaltwandlern (W1, W2, ...., WN) ein gemeinsamer Ausgangs-Glättungskondensator (C2) zugeordnet ist, der mit dem Ausgangs-Summenpunkt (SP2) verbunden ist, und die Schaltwandler (W1, W2, ...., WN) von der Schaltung (S) zur Reduzierung der effektiven Strombelastung des gemeinsamen Eingangs-Pufferkondensators (C1) sowie des gemeinsamen Ausgangs-Glättungskondensators (C2) phasenverschoben angesteuert werden, dadurch gekennzeichnet, dass die Schaltung (S) zur Ansteuerung von zwei parallel angeordneten Schaltwandlern (W1, W2) einen Rechteckgenerator (RG) zur Erzeugung eines Rechtecksignals aufweist, der mit je einem Monoflop (M1, M2) zur Triggerung dieser verbunden ist, wobei das erste Monoflop (M1) durch die ansteigende Flanke des Rechtecksignals und das zweite Monoflop (M2) durch die abfallende Flanke des Rechtecksignals zur Erzeugung einer konstanten Phasenverschiebung (P) getriggert wird, dass die Monoflops (M1, M2) zur Bestimmung der der Pulsweite entsprechenden Kippzeit mit einem gemeinsamen Sollwertgeber (SG) verbunden sind und dass das erste Monoflop (M1) mit dem ersten Schaltwandler (W1) und das zweite Monoflop (M2) mit dem zweiten Schaltwandler (W2) verbunden ist.

**2.** Schaltwandler nach Anspruch 1, dadurch gekennzeichnet, dass der Sollwertgeber (SG) eine gesteuerte Stromquelle ist.

**3.** Schaltwandler nach Anspruch 2, dadurch gekennzeichnet, dass das Rechtecksignal zur Erzeugung einer konstanten Phasenverschiebung (P) von 180 Grad symmetrisch ausgebildet ist.

## Claims

**1.** A pulse width-modulated switching converter for operating electrical consumers, particularly in vehicles, which is connected firstly to the supply voltage (UB) and secondly to the consumer, and which consists of a switching converter (W1), a circuit (S) for generating signals for triggering the switching converter (W1), and of an input buffer capacitor (C1) and an output smoothing capacitor (C2), wherein at least one second switching converter (W2) is connected in parallel with the switching converter (W1), the switching converters (W1, W2,...., WN) are connected via a common cumulative input point (SP1), the switching converters (W1, W2,..., WN) are connected via a common cumulative output point (SP2), a common input buffer capacitor (C1) is associated with the switching converters (W1, W2,...., WN) and is connected to the cumulative input point (SP1), a common output smoothing capacitor (C2) is associated with the switching converters (W1, W2,...., WN) and is connected to the cumulative output point (SP2), and the switching converters (W1, W2,...., WN) are triggered shifted in phase by the circuit (S) in order to reduce the effective current loading of the common input buffer capacitor (C1) and of the common output smoothing capacitor (C2), characterised in that the circuit (S) for triggering two switching converters (W1, W2) which are disposed in parallel comprises a rectangular generator (RG) for generating a rectangular signal, which generator is connected to a monoflop (M1, M2) for triggering the switching converters, wherein the first monoflop (M1) is triggered by the ascending flank of the rectangular signal and the second monoflop (M2) is triggered by the descending flank of the rectangular signal in order to generate a constant phase shift (P), that the monoflops (M1, M2) are connected to a common set value transmitter (SG) in order to determine the flop-over time corresponding to the pulse width, and that the first monoflop (M1) is connected to the first switching converter (W1) and the second monoflop (D2) is connected to the second switching converter (W2).

**2.** A switching converter according to claim 1, characterised in that the set value transmitter (SG) is a controlled source of current.

**3.** A switching converter according to claim 2, characterised in that the rectangular signal is of symmetrical form in order to produce a constant phase shift (P) of 180 degrees.

## Revendications

**1.** Convertisseur de commutation modulé selon une modulation d'impulsions en durée pour faire fonctionner des appareils d'utilisation électriques, notamment dans des véhicules automobiles, qui est relié d'une part à la tension d'alimentation (UB) et d'autre part à l'appareil d'utilisation, et est constitué par un convertisseur de commutation (W1), un circuit (S) servant à produire des signaux pour commander le convertisseur de commutation (W1) et un condensateur tampon d'entrée (C1) ainsi qu'un condensateur de lissage de sortie (C2), et dans lequel au moins un second convertisseur de commutation (W2) est branché en parallèle avec le convertisseur de commutation (W1), les convertisseurs de commutation (W1,W2, ..., WN) sont reliés par l'intermédiaire d'un point de sommation commun d'entrée (SP1), les convertisseurs de commutation (W1,W2,...,WN) sont reliés par l'intermédiaire d'un point commun de sommation de sortie (SP2), un condensateur tampon d'entrée commun (C1), qui est relié au point de sommation d'entrée (SP1), est associé aux convertisseurs de commutation (W1,W2,...,WN), un condensateur de lissage de sortie commun (C2), qui est relié au point de sommation de sortie (SP2), est associé aux convertisseurs de commutation (W1,W2,...,WN), et les convertisseurs de commutation (W1,W2,...,WN) sont commandés de façon déphasées pour réduire la charge effective en courant appliquée au condensateur tampon d'entrée (C1) ainsi qu'au condensateur de lissage de sortie commun (C2), caractérisé en ce que le circuit (S) pour commander deux convertisseurs de commutation (W1,W2) branchés en parallèle comporte un générateur de signal rectangulaire (RG) servant à produire un signal rectangulaire, qui est relié à un multivibrateur monostable respectif (M1,M2) pour le déclenchement de ce circuit, le premier multivibrateur monostable (M1) étant déclenché par le flanc montant du signal rectangulaire, et le second multivibrateur monostable (M2) étant déclenché par le flanc retombant du signal rectangulaire pour la production d'un déphasage constant (P) de telle sorte que les multivibrateurs monostables (M1,M2) sont reliés à un générateur commun de valeur de consigne (SG) pour la détermination du temps de basculement correspondant à la durée d'impulsions, et que le premier multivibrateur monostable (M1) est relié au premier convertisseur de commutation (W1) et le second multivibrateur monostable (M2) est relié au second convertisseur de commutation (W2).

2. Convertisseur de commutation selon la revendication 1, caractérisé en ce que le générateur de valeurs de consigne (SG) est une source de courant commandée.

3. Convertisseur de commutation selon la revendication 2, caractérisé en ce que le signal rectangulaire est conçu pour produire un déphasage constant symétrique (P) de 180 degrés.

Fig.1

Fig.2